# EUROPÄISCHE PATENTSCHRIFT

(11) **EP 1 990 219 B1**
(45) Veröffentlichungstag und Bekanntmachung des Hinweises auf die Patenterteilung: **01.09.2010**
(21) Anmeldenummer: 08008638.2
(22) Anmeldetag: 08.05.2008
(51) Int. Cl.: B60C 23/04

(54) **Radelektronik und Reifenkontrollsystem zur Messung einer Messgröße**
Wheel electronics and tyre monitoring system for measuring an indicator
Electronique de roue et système de surveillance des pneus pour la mesure d'une grandeur de mesure

(30) Priorität: 10.05.2007 DE 102007021859
(43) Veröffentlichungstag der Anmeldung: 12.11.2008
(73) Patentinhaber: Atmel Automotive GmbH, 74072 Heilbronn (DE)
(72) Erfinder: Abt, Christof, 71522 Backnang (DE)
(74) Vertreter: Müller, Wolf-Christian

(56) Entgegenhaltungen:
- JP-A- 1 259 617
- JP-A- 64 000 813
- US-A- 4 926 072
- US-A1- 2002 084 841
- US-A1- 2002 114 406
- US-A1- 2006 079 190

## Beschreibung

Die Erfindung betrifft eine Radelektronik in oder für ein Reifenkontrollsystem eines Fahrzeugs zur Messung einer Messgröße sowie ein solches Reifenkontrollsystem.

Die vorliegende Erfindung bezieht sich auf Systeme zur Überwachung oder Ermittlung reifenspezifischer Parameter, wie etwa der Reifentemperatur, den Reifendruck, die Umdrehungsgeschwindigkeit eines Rades, die Profildicke, etc. Solche Systeme werden allgemein als Reifeninformationssysteme, Reifenkontrollsysteme oder auch Reifendruckkontrollsysteme bezeichnet. Die Erfindung sowie die ihr zugrunde liegende Problematik wird nachfolgend mit Bezug auf ein Reifendruckkontrollsystem erläutert, jedoch ohne die Erfindung dahingehend zu beschränken.

Da die Fahrzeugsicherheit und Zuverlässigkeit zentrale Faktoren in der Automobiltechnik sind, muss allein schon aus sicherheitstechnischen Gründen der Reifendruck von Kraftfahrzeugen regelmäßig überprüft werden. Dies wird häufig versäumt. Moderne Kraftfahrzeuge weisen u. a. aus diesem Grund Reifendruckkontrollsysteme auf, die den Reifendruck automatisch messen und eine kritische Abweichung des gemessenen Reifendrucks von einem Reifendrucksollwert frühzeitig erkennen sollen. Eine manuelle Überprüfung wird so entbehrlich.

Ein solches Reifendruckkontrollsystem weist typischerweise zumindest eine, einem jeweiligen Rad zugeordneten Radelektronik mit darin enthaltenem Radsensor auf. Ein solcher Radsensor ist dazu ausgelegt, einen reifenspezifischen Parameter eines jeweils diesem Radsensor zugeordneten Rades aufzunehmen und eine von diesem gemessenen Wert abgeleitete Information auszusenden. Der Radsensor ist z. B. im Gummimaterial des Reifens integriert, beispielsweise ist er im Gummi des Reifens einvulkanisiert. Für die Vorauswertung und Weiterleitung der aufgenommenen und zu sendenden Informationen weist die Radelektronik eine Sendeantenne, über die die Informationen ausgesendet werden, auf. Fahrzeugseitig weist das Reifendruckkontrollsystem zumindest eine Empfangseinrichtung auf, welche die von der Reifenelektronik ausgesendeten Signale mit den darin enthaltenen Informationen aufnimmt und an eine zentrale Recheneinheit weiterleitet.

Zwischen einer jeweiligen Radelelektronik und der ihr zugeordneten fahrzeugseitigen Empfangseinrichtung findet eine typischerweise bidirektionale Datenkommunikation statt. Bei dieser bidirektionalen Datenkommunikation, die beispielsweise nach einem bekannten Challenge-Response-Verfahren erfolgt, wird von der fahrzeugseitigen Basisstation über eine Sendereinrichtung zunächst ein Anfragesignal (Challenge) an die Radelelektronik gesendet und von der Radelektronik auf diese Anfrage hin eine Antwortwortsignal (Response) zurück gesendet.

Ein allgemeines Problem bei Reifendruckkontrollsystemen ergibt sich durch die drahtlose Kommunikation zwischen Radelektronik und Fahrzeug, die eine lokale Energieversorgung seitens der Radelektronik erforderlich macht. In vielen Reifendruckkontrollsystemen ist die Radelektronik daher mit einer Batterie oder einem Akkumulator ausgestattet. Um einen möglichst geringen Energieverbrauch zu gewährleisten und um so die Batterie der Reifenelektronik zu schonen, erfolgt eine Messung im Messsensor nicht kontinuierlich, sondern auf eine entsprechende Anfrage hin. Hierzu sendet die Basisstation eine Aufforderung (i. e. Anfrage) zur Luftdruckmessung an die Radelektronik.

Die Radelektronik veranlaßt den Radsensor, eine Messung vorzunehmen, sofern sie eine Aufforderung als solche erkennt.

Aufgrund der drahtlosen Übertragungsstrecke zwischen fahrzeugseitigem Sender und radseitigem Empfänger kann es allerdings zu Übertragungsfehlern des gesendeten Anforderungssignals kommen. Beispielsweise können Störimpulse und Signaleinbrüche im Anforderungssignal auftreten. Störimpulse können beispielsweise durch andere Signalquellen hervorgerufen werden, beispielsweise durch Sendeeinrichtungen anderer Verkehrsteilnehmer in der unmittelbaren Umgebung des Reifendruckkontrollsystems, oder etwa auch durch andere Funksignale, die von dem gesendeten Anforderungssignal überlagert werden und dieses stören. Zudem können solche Störsignale auch durch Signalquellen Innerhalb des Fahrzeuges entstehen und unerwünschterweise dem Anforderungssignal überlagert werden. Signaleinbrüche hingegen entstehen beispielsweise dann, wenn die drahtlose Schnittstelle zwischen fahrzeugseitigem Sender und radelektronikseitigem Empfänger zumindest zeitweise oder abschnittsweise unterbrochen ist. Diese Signaleinbrüche können dann auftreten, wenn beispielsweise bei einer hohen Geschwindigkeit der Reifendruck gemessen werden soll. In diesem Falle steht dem am Reifen angebrachten Radsensor nur eine geringe Zeit zur Verfügung, eine Datenkommunikation mit dem fahrzeugseitigen Sender/Empfänger aufzubauen und eine Datenkommunikation durchzuführen. Darüber hinaus kann auch die Karosserie des Fahrzeuges selbst zumindest teilweise oder abschnittsweise als Blende für das gesendete Anforderungssignal fungieren.

Aus der US 2006/ 0079190 A1 und der US2002 / 0084841 A1 sind Transponder basierte Relfendruckmesssysteme bekannt. Des Weiteren sind aus der US 2002/0114406 A1, der JP 64 00813 A, der JP 01 259617 und der US 4 926 072 A digitale Schaltungen zur Rauschunterdrückung bekannt.

Ist ein Anforderungssignal mit mehr oder weniger starken Signaleinbrüchen behaftet oder durch Störimpulse gestört, dann kann eine im Anforderungssignal enthaltene Anfrage nicht als solche erkannt werden. In der Folge bedeutet dies, dass der Messsensor keine Reifendruckmessung durchführt. Dies ist ein Zustand, den es bei der Reifendruckmessung Insbesondere aus sicherheitstechnischen Gründen möglichst zu vermeiden gilt.

Vor diesem Hintergrund Ilegt der vorliegenden Erfindung die Aufgabe zugrunde, bei einem Reifenkontrollsystem den Einfluss von Störimpulsen und/oder Signaleinbrüchen auf die Messung der zu messenden Messgröße zumindest zu reduzieren.

Diese Aufgabe wird durch eine Reifenelektronik mit den Merkmalen des Patentanspruchs 1 gelöst.

Demgemäß ist ein vorgesehen:

Eine Radelektronik für ein Reifenkontrollsystem eines Fahrzeugs zur Messung einer Messgröße, mit einer Auswerteeinrichtung, zur Dekodierung eines empfangenen amplitudenmodulierten Anfragesignals, mit einer Trägerfrequenz, indem aus dem modulierten Trägersignal eine Einhüllende ermittelt wird, aufweisend einem digitalen Zähler der einen Zählereingang zur Einkopplung des Anfragesignals aufweist, aufweisend ein Schieberegister , das eingangsseitig mit einem Zählerausgang des Zählers verbunden ist, und das und einer mit dem Ausgang des Schieberegisters verbundenen Logikschaltung.

Ein Reifenkontrollsystem in oder für ein Fahrzeug, mit einer fahrzeugseitigen Basisstation, die zumindest eine erste Sende-/Empfangseinrichtung aufweist, mit mindestens einer Radelektronik nach einem der vorherigen Ansprüche, die jeweils eine zweite Sende-/Empfangseinrichtung aufweist, wobei zur Ermittlung reifenspezifischer Parameter in einer Radelektronik eine Datenkommunikation zwischen der Basisstation und der Radelektronik nach dem Challenge-Response-Verfahren vorgesehen ist.

Die Erfindung geht von einem Reifenkontrollsystem aus, welches nach einem bekannten Challenge-Response-Verfahren arbeitet, bei dem die Reifenelektronik und hier insbesondere deren Messsensor lediglich dann eine Messung durchführt, wenn diese von der Basisstation durch ein entsprechendes Anfragesignal über eine drahtlose Kommunikationsstrecke an die Reifenelektronik angefordert wird. Die Anfrage wird durch ein amplitudenmoduliertes Anfragesignal gesendet. Vorzugsweise liegt die Frequenz des Trägersignals bei 125 kHz. Die Information wird dabei durch Modulation der Amplitude, beispielsweise in Form einer Pulsweitenmodulation dem Trägersignal aufmoduliert.

Die der vorliegenden Erfindung zugrunde liegende Idee besteht nun darin, eine Einhüllende für dieses Trägersignals zu erzeugen und auf diese Weise die entsprechende Anfrage aus der Einhüllenden zu dekodieren. Für die Bildung dieser Einhüllenden wird das amplitudenmodulierte Anfragesignal digitalisiert. Die der vorliegenden Erfindung zugrunde liegende Idee besteht ferner darin, dieses digitalisierte Anfragesignal einem digitalen Zähler zuzuführen, der die Einhüllende ermittelt. Hierzu wird der Zähler durch ein Taktsignal getaktet, dessen Frequenz zumindest unterschiedlich ist wie die Frequenz des Trägersignals. Auf diese Weise kann die Einhüllende des amplitudenmodulierten Anfragesignals auf sehr einfache, jedoch sehr effektive Weise ermittelt werden. Somit wird durch die vorliegende Erfindung gewissermaßen ein digitales Filter geschaffen, welches unter Verwendung eines beispielsweise 90 kHz Takt Signals Störimpulse und Signaleinbrüche sehr effektiv aus dem amplitudenmodulierten Anfragesignal herausfiltert.

Der Zähler als Gray-Zähler ausgeführt. Da sich der Gray-Zähler beim Hochzählen immer nur um ein Bit pro Takt ändert, ergibt sich damit in sehr vorteilhafter Weise ein besonders stabiles Verhalten der erfindungsgemäßen Filteranordnung.

In sehr überraschender Weise lassen sich hier Störimpulse und Signaleinbrüche, welche im amplitudenmodulierten Anfragesignal und hier insbesondere im Bereich dessen Trägersignals vorhanden sind, durch die Bildung der Einhüllenden vermieden werden. Durch das Bereitstellen eines digitalen Zählers zur Ermittlung der Einhüllenden wird gewissermaßen ein digitales Filter geschaffen, welches durch Mittelwertbildung geringe Störungen oder Signaleinbrüche im hochfrequenten Trägersignal herausmittelt und somit eliminiert. Auf diese Weise kann sehr effektiv zudem sehr einfach ein relativ störunempfindliches Verfahren bereitgestellt werden, eine Anfrage aus einem Anfragesignal heraus zu ermitteln.

Vorteilhafte Ausgestaltungen und Weiterbildungen der Erfindung ergeben sich aus den weiteren Unteransprüchen sowie aus der Beschreibung in Zusammenschau mit den Figuren der Zeichnung.

In einer bevorzugten Ausgestaltung ist der Zähler als 3-Bit-Zähler und hier insbesondere als 3-Bit-Gray-Zähler ausgebildet. Durch diese 3 Bits ergeben sich insgesamt acht mögliche Zustände. Es hat sich gezeigt, dass diese 3 Bit und die damit möglichen 8 Zustände häufig bereits ausreichend sind, um eine hohe Störsicherheit zu gewährleisten. Denkbar wäre selbstverständlich auch, lediglich einen 2-Bit-Zähler oder einen mehr als 3-Bit-Zähler bereit zu stellen, je nach dem, wie die zu erwartenden Störimpulse und/oder Signaleinbrüche geartet sind bzw. welche Störsicherheit durch die erfindungsgemäße Radelektronik bereit gestellt werden soll.

In einer bevorzugten Ausgestaltung ist ein Schieberegister vorgesehen, das eingangsseitig mit einem Zählerausgang des Zählers verbunden ist. Vorzugsweise ist dabei das Schieberegister als mehrstufiges Schieberegister ausgebildet, welches mehrere in Reihe zueinander angeordnete Schieberegisterzellen aufweist. Vorzugsweise ist dabei das Schieberegister als fünfstufiges Schieberegister ausgebildet und enthält somit insgesamt fünf Schieberegisterzellen. Dieses fünfstufige Schieberegister weist somit maximal fünf Schieberegisterausgänge auf. Je nach Applikation kann auf den einen oder anderen Ausgang der Schieberegisterzellen, beispielsweise auf den ersten Ausgang, der unmittelbar nach der ersten Schieberegisterzelle vorgesehen ist, auch verzichtet werden. Durch das Bereitstellen eines solchen Schieberegisters lassen sich selbst kürzeste Störimpulse und Signaleinbrüche vermeiden. Durch das Bereitstellen des Schieberegisters wird gleichzeitig am Ausgang des Schieberegisters die Einhüllende erzeugt, die leicht zeitversetzt zum amplitudenmodulierten Anfragesignal ist, was jedoch nicht weiter störend ist, da als Ergebnis mit hoher Sicherheit und störungsunempfindlich die Einhüllende des amplitudenmodulierten Anfragesignals generiert werden kann. Je nach Länge des Schieberegisters, d. h. je nach Anzahl der nacheinander angeordneten Schieberegisterzellen, lässt sich bestimmen, welche Störempfindlichkeit die Radelektronik aufweisen soll. Ein sehr guter Kompromiss zwischen der Dynamik für die Erzeugung der Einhüllenden und der Störungsunempfndlichkeit besteht darin, wenn mehr als drei und weniger als sieben Schieberegisterzellen und insbesondere fünf Schieberegisterzellen vorgesehen sind. Eine höhere Schieberegisteranzahl ist zwar möglich, jedoch verschiebt sich dadurch das digitale Signal bzw. die Einhüllende gegenüber dem Trägerfrequenzsignal. Auch führt eine höhere Schieberegisteranzahl zu höheren Kosten der Radelektronik. Durch das Schieberegister ist es möglich, dass eine Reihe von Impulsen der Trägerfrequenz aufeinander folgen müssen, ansonsten erkennt die Schieberegisterschaltung, dass ein fehlendes Signal durch ein Störimpuls verursacht worden ist.

In einer bevorzugten Ausgestaltung ist ein Messsensor vorgesehen, der eine Messung der zu ermittelten physikalischen Messgröße nur bei Vorhandensein der Anfrage durchführt. Der Messsensor kann dazu ausgelegt sein, den Reifendruck, die Reifentemperatur oder andere Reifen-spezifische Parameter, wie z. B. die Umdrehungsgeschwindigkeit eines Rades, die Profildicke eines Reifens und dergleichen, zu ermitteln.

In einer ebenfalls bevorzugten Ausgestaltung ist eine zweite Auswerteschaltung vorgesehen, die so ausgebildet ist, dass jeder der Ausgangsanschlüsse des Schieberegisters und damit jeder Ausgangsanschluss einer jeweiligen Schieberegisterzelle mit einem Eingang der Auswerteschaltung verbunden ist. Diese zweite Auswerteschaltung kann beispielsweise als Logikschaltung ausgebildet sein oder auch als Bestandteil des Mikrokontrollers implementiert sein. Die zweite Auswerteschaltung ist derart ausgebildet, dass sie abhängig von der Taktfrequenz des Taktsignals und den von den verschiedenen Schieberegisterzellen ermittelten Ausgangsbits ausgangsseitig einen jeweiligen logischen Pegel erzeugt. Dabei gibt die zweite Auswerteschaltung an ihrem Ausgangsanschluss einen ersten logischen Pegel, beispielsweise eine logische "0" oder einen niedrigen logischen Pegel aus, wenn alle Schieberegisterzellen den gleichen Ausgangswert aufweisen. Umgekehrt gibt die zweite Auswerteschaltung ausgangsseitig einen zweiten logischen Pegel, beispielsweise eine logische "1" oder einen hohen logischen Pegel aus, wenn sämtliche Ausgangswerte der Schieberegisterzellen zumindest teilweise unterschiedlich sind. Denkbar ist hier selbstverständlich auch eine umgekehrte Logik.

Typischerweise wird das Schieberegister und somit deren Schieberegisterzellen von dem Taktsignal getaktet.

In einer bevorzugten Ausgestaltung ist ein Flip-Flop und hier insbesondere ein D-Flip-Flop, vorgesehen, dessen Dateneingang mit dem Ausgangsanschluss der zweiten Auswerteschaltung verbunden ist und in dessen Takteingang das Taktsignal eingekoppelt wird. Am Ausgang dieses Flip-Flops wird somit getriggert durch das Taktsignal durch Verknüpfung des Ausgangssignals der zweiten Auswerteschaltung und des Taktsignals die Einhüllende erzeugt.

In einer bevorzugten Ausgestaltung ist eine programmgesteuerte Einrichtung vorgesehen, die zumindest die Funktion der ersten Auswerteeinrichtung enthält. Zusätzlich oder alternativ kann auch vorgesehen sein, dass diese programmgesteuerte Einrichtung die Funktion der zweiten Auswerteeinrichtung und/oder des Zählers und/oder des Flip-Flops umfasst. Diese programmgesteuerte Einrichtung kann als Mikrokontroller, Mikroprozessor oder dergleichen ausgebildet sein oder auch als festverdrahtete Logikschaltung, wie z. B. als PLD oder FPGA, implementiert sein.

In einer typischen Ausgestaltung enthält die Radelektronik eine lokale Energieversorgung, die die Elemente der Radelektronik mit Energie versorgt. Insbesondere versorgt diese Energieversorgung, die zum Beispiel als Batterie oder als aufladbarer Akkumulator ausgebildet sein kann, den Mikrokontroller, den Messsensor, die Auswerteeinrichtungen, den Zähler und das Flip-Flop der Radelelektronik mit Energie.

In einer bevorzugten Ausgestaltung des erfindungsgemäßen Reifenkontrollsystems liegt eine Frequenz des Trägersignals des von der fahrzeugseitigen ersten Sende-/Empfangseinrichtung an die Radelektronik gesendeten amplitudenmodulierten Anfragesignals im Kurzwellenfrequenzbereich. Diese Frequenz führt zu geringen Störungen in anderen Systemen des Kraftfahrzeugs, was in einem Kraftfahrzeug relativ wichtig ist.

Vorzugsweise ist die Frequenz des Taktsignals der Radelektronik zumindest kleiner als die Frequenz des Trägersignals. Das erfindungsgemäße Reifenkontrollsystem arbeitet sehr sicher, wenn die Frequenz des Taktsignals der Radelektronik zumindest die Hälfte der Frequenz des Trägersignals des von der ersten Sende-/Empfangseinrichtung an die Radelektronik gesendeten amplitudenmodulierten Anfragesignals liegt. Vorzugsweise beträgt die Frequenz des Trägersignals 125 kHz und die Frequenz des Taktsignals 90 kHz.

Die vorliegende Erfindung wird nachfolgend anhand der in den Figuren der Zeichnung angegebenen Ausführungsbeispiele näher erläutert. Es zeigen dabei:
- Fig. 1: eine schematische Draufsicht eines Pkws zur Erläuterung des erfindungsgemäßen Reifendruckkontroilsystems;
- Fig. 2: ein Blockschaltbild eines beispielhaften Aufbaus einer Radelektronik;
- Fig. 3: ein Signalzeitdiagramm eines amplitudenmodulierten Anfragesignals mit darauf aufmoduliertem Trägersignal, die Einhüllende des amplitudenmodulierten Signals und das Taktsignal;
- Fig. 4: eine Schaltungsanordnung mit einem Gray-Zähler, einer Schieberegisteranordnung und einem D-Flip-Flop zur Erläuterung eines ersten Ausführungsbeispiels für eine erfindungsgemäße Radelektronik;
- Fig. 5: ein Kodierungsschema für die möglichen Ausgangszustände des Gray-Zählers;
- Fig. 6: eine Schaltungsanordnung mit einer Schieberegisteranordnung, einer Logikschaltung und einem Flip-Flop zur Erläuterung eines zweiten Ausführungsbeispiels der erfindungsgemäßen Radelektronik.
- Fig. 7: eine Schaltungsanordnung mit einer Schieberegisteranordnung, einer Logikschaltung und einem Flip-Flop zur Erläuterung eines weiteren Ausführungsbeispiels der erfindungsgemäßen Radelektronik.

In den Figuren der Zeichnung sind gleiche und funktionsgleiche Elemente, Merkmale und Signale, sofern nichts Anderes angegeben ist, mit denselben Bezugszeichen versehen.

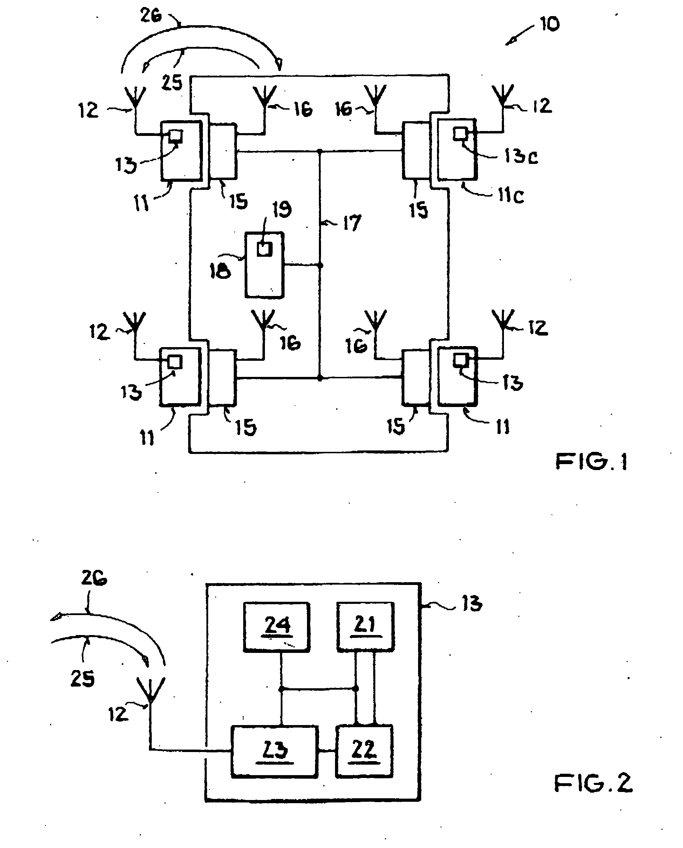

Figur 1 zeigt anhand einer schematischen Draufsicht auf einen Pkw ein Ausführungsbeispiel eines erfindungsgemäßen Reifendrucksystems. In Figur 1 ist mit Bezugszeichen 10 das Fahrzeug, beispielsweise ein Personenkraftfahrzeug (Pkw), bezeichnet. Das Fahrzeug 10 weist im vorliegenden Ausführungsbeispiel vier Räder 11 auf. Jedes dieser Räder 11 ist in bekannter Art und Weise an einer hier nicht dargestellten Achse befestigt.

Das Fahrzeug 10 verfügt über ein erfindungsgemäßes Reifenkontrollsystem, welches im vorliegenden Ausführungsbeispiel als Reifendruckkontrollsystem zur Ermittlung beispielsweise des Reifendrucks ausgelegt ist. Darüber hinaus soll dieses Reifendruckkontrollsystem dazu ausgelegt sein, die so ermittelten Informationen des Reifendruckes auch auszuwerten und gegebenenfalls anzuzeigen. Dieses Reifendruckkontrollsystem weist radseitige elektronische Radeinrichtungen, nachfolgend auch als Radelektroniken bezeichnet, fahrzeugseitige Sende-/Empfangseinrichtungen, einen Bus sowie ein Steuergerät auf. Diese Elemente des Reifendruckkontrollsystems sowie deren Anordnungen und Funktionen werden nachfolgend erläutert:

Jedem einzelnen Rad 11 ist zumindest eine Radelelektronik 13 zugeordnet. Diese Radelektronik 13 kann in an sich bekannter Weise beispielsweise innerhalb eines jeweiligen Reifens, also in dessen Gummimaterial, und/oder im Bereich des Ventils oder der Felge des Rades 11 angeordnet sein. Eine jeweilige Radelektronik 13 umfasst typischerweise einen Radsensor, der dazu ausgelegt ist, radspezifische Parameter, wie z. B. den Reifendruck, die Reifentemperatur, die Umdrehungsgeschwindigkeit eines Rades, die Profiltiefe des Reifens und gegebenenfalls auch andere Parameter, zu ermitteln. Die Radelelektronik 13 umfasst ferner eine Sende-/Empfangsantenne 12.

Figur 2 zeigt anhand eines schematischen Blockschaltbildes einen beispielhaften Aufbau einer solchen Radelektronik 13. Die Radelektronik 13 weist im Falle des vorliegenden Ausführungsbeispiels einen Drucksensor 21, eine mit dem Drucksensor 21 verbundene Verarbeitungseinrichtung 22 und eine mit der Verarbeitungseinrichtung 22 verbundene Sender-/Empfängerschaltung 23 auf, die jeweils von einer lokalen Energieversorgung 24, beispielsweise einem Akkumulator oder einer Batterie, mit elektrischer Energie versorgt werden. Diese Radelektronik 13 ist dafür vorgesehen, mittels des Drucksensors 21 den aktuellen Reifendruck des jeweiligen Rades zu messen.

Die Radelektronik 13 ist dazu vorgesehen, über die Sende-/Empfangsantenne 12 und die Sender-/Empfängerschaltung 23 ein fahrzeugseitig gesendetes, amplitudenmoduliertes Signal 25 aufzunehmen und an die Verarbeitungseinrichtung weiterzugeben. In der Verarbeitungseinrichtung 22 erfolgt eine Demodulierung, Dekodierung und Auswertung des empfangenen Signals. Beispielsweise enthält das von der Radelektronik 13 aufgenommene Signal eine Anfrage, die in dem amplitudenmodulierten Signal codiert ist. Die Verarbeitungseinrichtung 22 ermittelt aus dem empfangenen amplitudenmodulierten Signal die darin enthaltene Anfrage, wie nachfolgend noch detailliert beschrieben wird.

Die Verarbeitungseinrichtung 22 ist u. a. dafür vorgesehen, eine Nachricht (i. e. Antwort) als Sendesignal 26 z. B. über den gemessenen Reifendruck zu erzeugen und diese Nachricht anschließend mittels die Sender-/Empfängerschaltung 23 und die Antenne 12 drahtlos als Antwort an eine fahrzeugseitige Empfangseinrichtung 15 zu senden:

Zum Empfangen der radseitig gesendeten Sendesignale 26 weist das Reifendruckkontrollsystem fahrzeugseitig mehrere Empfangseinrichtungen 15, die jeweils eine Sende-/Empfangsantenne 16 umfassen, auf. Das von der Sende-/Empfangsantenne 16 über die Empfangseinrichtung 15 aufgenommene Sendesignal 26 wird über einen internen Bus 17 einer zentralen Steuereinheit 18 zugeführt, die eine Recheneinheit 19, beispielsweise eine als Mikrokontroller ausgebildete programmgesteuerte Einrichtung, aufweist. In dieser Recheneinheit 19 erfolgt die Auswertung der von einer jeweiligen Radelektronik 13 gesendeten Nachricht.

Der Drucksensor 21 misst einen Reifendruck lediglich dann, wenn er eine entsprechende Anfrage erhält. Ansonsten ist der Drucksensor 21 deaktiviert. Zum Aktivieren des Drucksensors 21 erzeugt die zentrale Steuereinheit 18 ein Anfragesignal 25, welches die Anfrage enthält, und sendet dieses Anfragesignal 25 über die Sende-/Empfangseinrichtung 15 und die Sende-/Empfangsantenne 16 an die ihr zugeordnete Radelektronik 13, welche das Anfragesignal 25 über deren Sende-/Empfangsantenne 12 aufnimmt.

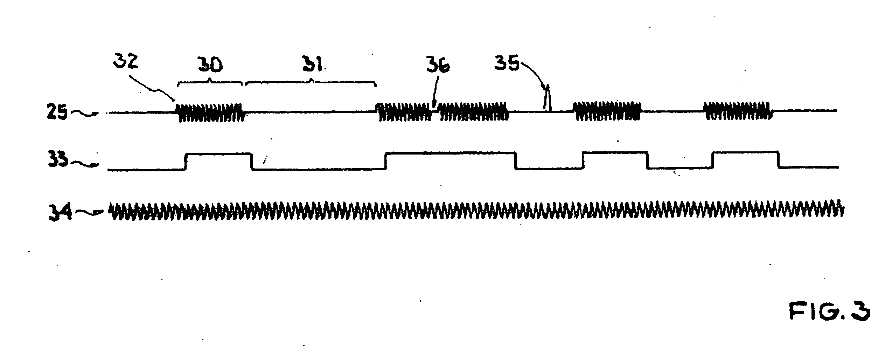

Bei diesem Anfragesignal 25 handelt es sich z. B. um ein amplitudenmoduliertes Signal mit einer abschnittsweisen 125 kHz Trägerfrequenz. Figur 3 zeigt anhand eines Signalzeitdiagramms ein Beispiel für den Verlauf eines solchen amplitudenmodulierten Anfragesignals 25. Dieses Anfragesignal 25 weist erste Abschnitte 30 und zweite Abschnitte 31 auf. Die ersten Abschnitte des Anfragesignals 25 weisen ein Trägersignal 32 auf, wohingegen die zweiten Abschnitte kein Trägersignal 32 umfassen. Das Trägersignal 32 ist im vorliegenden Fall ein hochfrequentes, beispielsweise 125 kHz ein Trägersignal. Die Länge der ersten und zweiten Abschnitte und/oder deren Abstände zueinander enthalten die kodierten Informationen und somit die in dem amplitudenmodulierten Anfragesignal 25 enthaltenen Anfrageinformationen.

Figur 3 zeigt ferner das sich aus dem amplitudenmodulierten Signal ergebende einhüllende Signal 33, das nachfolgend auch kurz als Einhüllende 33 des amplitudenmodulierten Anfragesignals 25 bezeichnet wird. Ferner ist in der Figur 3 noch ein Taktsignal, im vorliegenden Fall ein 90 kHz Taktsignal, dargestellt, welches intern in der Radelektronik 13 vorgesehen ist. Lediglich beispielhaft ist in der Figur 3 ein Störimpuls 35 und ein Signaleinbruch 36 im amplitudenmodulierten Anfragesignal 25 bzw. dessen Trägersignal 32 dargestellt. Wie nachfolgend noch detailliert beschrieben wird, werden mittels der vorliegenden Erfindung diese Störungen 35, 36 herausgefiltert, sodass diese Störungen 35, 36 in der erfindungsgemäß erzeugten Einhüllenden 33 des amplitudenmodulierten Anfragesignals 25 nicht mehr sichtbar sind. Dies wird nachfolgend anhand schaltungstechnischer Ausführungsbeispiele, die in der Radelektronik 13 implementiert sind, detailliert beschrieben.

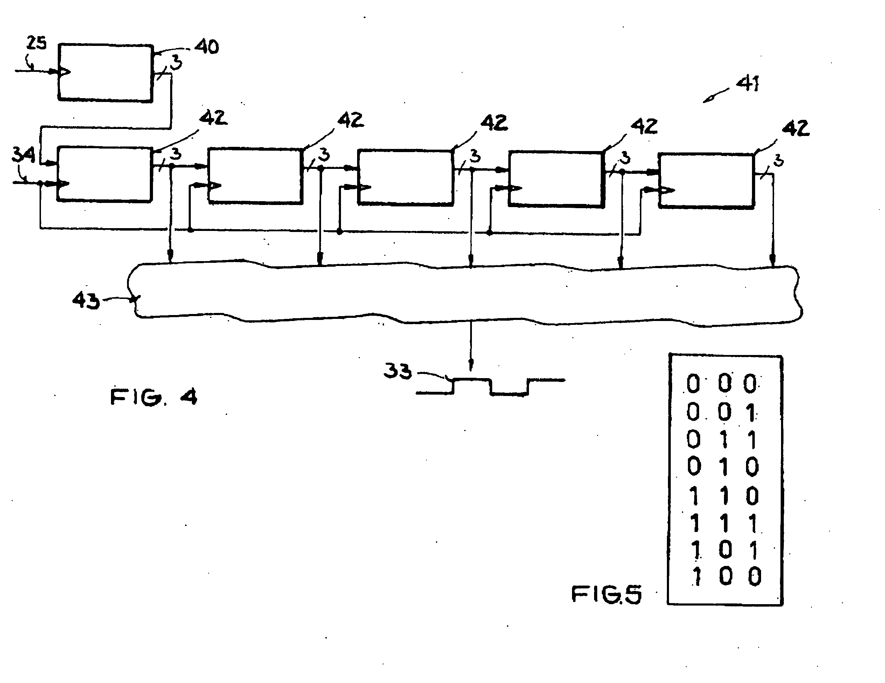

Die Fig. 4 zeigt eine bevorzugte Ausführungsform zur erfindungsgemäßen Generierung der Einhüllenden 33 aus dem amplituden modulierten 125 kHz-Anfragesignal 25. Ein derartige Dekodierung erfolgt vorzugsweise in der Verarbeitungseinrichtung 22. Erfindungsgemäß ist ein Zähler 40 vorgesehen, der vorzugsweise als Gray-Zähler ausgeführt ist. An seinem Zählereingang wird das amplitudenmodulierte 125 kHz-Anfragesignal 25 angelegt. Sein Ausgang ändert sich beim Hochzählen immer nur um 1 Bit pro Takt, wobei der Takt die Trägerfrequenz ist. Vorzugsweise ist der Gray-Zähler 40 als 3-Bitzähler ausgeführt. Die Bitfolge des Gray-Zählers ist in Fig. 5 veranschaulicht, wobei insgesamt acht Zustände vorgesehen sind. Der binäre Zählerausgang des Zählers 40 weist drei Ausgangsleitungen auf, die mit einem Schieberegister 41 bestehend aus fünf Registerstufen 42 verbunden sind. Entsprechend den drei Ausgängen des Gray-Zählers 40 weist jede Registerstufe 42 drei parallel geschalteten Flip-Flops, vorzugsweise flankengetriggerte D-Flip-Flops, auf. Demgemäß ist der jeweils ein Ausgang des Gray-Zählers 40 mit dem Eingang eines Flip-Flops der ersten Registerstufe 42 verschaltet. Des Weiteren ist der Ausgang jedes Flip-Flops der ersten Registerstufe mit dem Eingang eines Flip-Flops der zweiten Registerstufe verbunden. In der Figur 4 ist diese Verschaltung zwischen Gray-Zähler und erster Registerstufe und die Verschaltung zwischen den einzelnen Registerstufen mit einer Ziffer 3 angedeutet. Das Schieberegister 41, d.h. die insgesamt zwanzig Flip-Flops der fünf Registerstufen 42, werden durch das 90 kHz-Taktsignal 34 getaktet. Das Zählerergebnis des Gray-Zählers 40, also dessen aktueller Zählerstand, wird so praktisch nacheinander, also bitweise in die einzelnen Registerstufen 42 des Schieberegisters 41 geschoben und durchläuft dieses bitweise.

Insbesondere ist das Schieberegister 41 als fünfstufiges Schieberegister 41 ausgeführt, wobei in Fig. 4 beispielhaft fünf Schieberegisterstufen 42 vorhanden sind. Jeder der drei Ausgänge einer solchen Registerstufe 42 ist mit einer Logikschaltung 43 verbunden. In dem die Flip-Flops der Registerstufen unabhängig von dem Anliegen eines 125 KHz Eingangssignal 25 getaktet werden, werden die 3 Ausgänge des Gray-Zählers solange ausgelesen und die Bits durch das einzelnen Registerstufen geschoben, solange der 90 KHz Takt an den mit CP bezeichneten Takteingang der Flip-Flops anliegt. Liegt im Zeitraum 30 ein Eingangssignal 25 an dem Eingang des Gray-Zählers 40 an, ändern sich die Bit-Werte der Ausgänge des Gray-Zählers 40 kontinuierlich und damit auch die Bit-Werte an den Ein- bzw. Ausgängen der Flip-Flops der einzelnen Registerstufen 42, d.h. die Werte durchlaufen die einzelnen Registerstufen. Entsprechend ändern sich die Bit-Werte an den einzelnen Ausgängen der Registerstufen 42 nicht im Zeitraum 31 kurz nach dem Beginn des Zeitraums 31 nicht mehr, d.h. die Registerstufen werden beispielsweise mit dem Bitwert Null "gefüllt". Mittels der Logikschaltung 43 werden die Bitwerte der einzelnen Registerstufen 42 ausgewertet Lassen sich beispielsweise eine Vielzahl von "1" feststellen gibt die Logikschaltung 43 einen 1 als Einhüllende aus. Andernfalls gibt die Logikschaltung 43.ein "0" als Einhüllende aus. Demgemäß werden einzelne nadelförmige Impulse 35 und einzelne Einbrüche 36 zuverlässig ausgefiltert und insgesamt eine wirksame Unterdrückung von Signalstörungen erzielt.

In einer anderen Ausführungsform gibt die Logikschaltung 43 eine "0" aus, wenn der Wert (i. e. Bits) an den Ausgängen aller Schieberegisterstufen 42 überall gleich, vorzugsweise Null ist. Wenn jedoch die Werte an den Ausgängen jeder Schieberegisterstufe unterschiedlich sind, dann gibt die Logikschaltung 43 eine "1" aus.

Wie in Fig. 4 veranschaulicht ist, gibt die Logikschaltung 43 an ihrem Ausgang die gewünschte Einhüllende 33 aus, die sich aus dem logischen Pegel am Ausgang der Logikschaltung 43 ergibt. Diese Ausführungsvariante kann also, im Unterschied zu einem Dezimalzähler, maximal einen 1 Bit Fehler aufweisen.

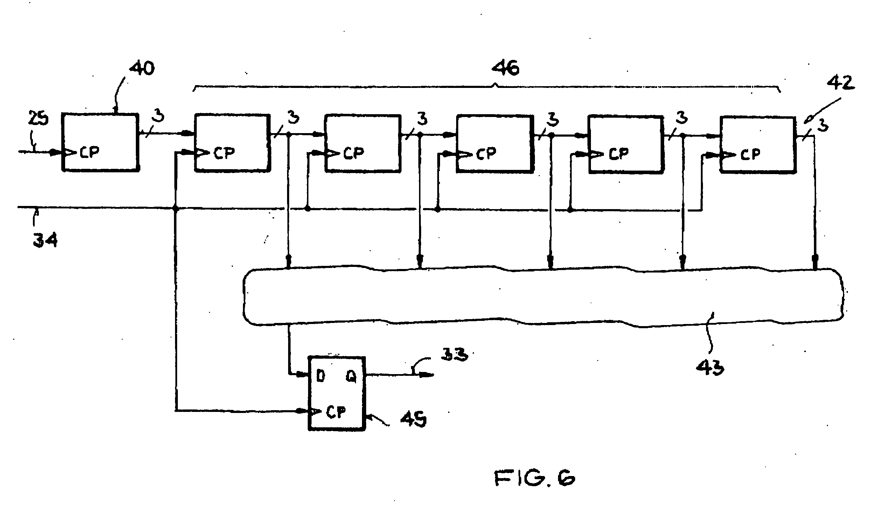

In Fig. 6 ist vorgesehen, dass der Ausgang der Logikschaltung 43 mit einem D-Flip-Flop 45 verbunden ist, der von dem 90 kHz-Takt 34 getaktet wird. Bei dem gezeigten Beispiel taktet praktisch das amplitudenmodulierte 125 kHz-Signal den Gray-Zähler 40. Dessen Werte werden auf das fünfstufige Schieberegister 41 geführt. Sind alle Werte des Schieberegisters 41, d. h. alle Ausgangsbits der verschiedenen Schieberegisterstufen 42, gleich, wird die Einhüllende "0", sind sie unterschiedlich wird die Einhüllende "1". Diese Schaltung filtert selbst einzelne nadelförmige Störimpulse 35 und Takteinbrüche 36 heraus, was bei herkömmlichen digitalen Filtern nicht möglich ist.

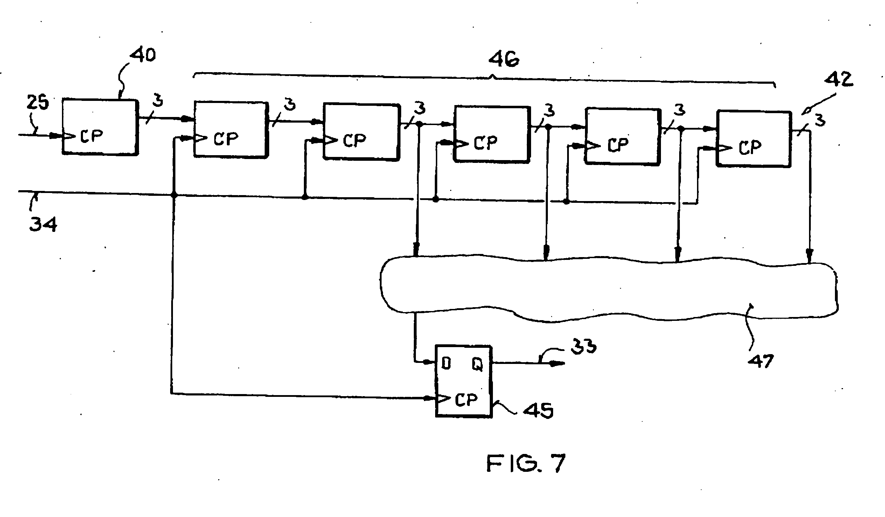

In einer anderen Ausführungsform, dargestellt in der Figur 7, sind nur die jeweils 3 Ausgänge der letzten 4 Registerstufen 42 eines Schieberegisters 46 mit einer asynchronen Auswertelogik 47 verbunden. Hierdurch lässt sich die Auswertelogik 47 platz- und stromsparender ausführen. Die Auswertelogik 47 wertet dann nur die letzten vier der fünf Registerstufen 42 aus. Vorzugsweise wird, wenn nur gleiche Werte, beipielsweise Nullen in den Registerstufen stehen, die Einhüllende 33 auf den Wert Null gesetzt, da davon ausgegangen wird, dass der Gray-Zähler 40 keine Takte am Eingang erhält. Entsprechend wird der Wert der Einhüllenden 33 auf "1" gesetzt, wenn mehrere unterschiedliche Werte in den Registerstufen vorgefunden werden.

### Bezugszeichenliste

- 10: Fahrzeug, Pkw
- 11: Rad
- 12: radseitige Sende-/Empfangsantenne
- 13: Radelektronik
- 15: fahrzeugseitige Sende-/Empfangseinrichtung
- 16: fahrzeugsseitige Sende-/Empfangsantenne
- 17: Bus
- 18: zentrale Steuereinheit
- 19: Recheneinheit, Mikrokontroller
- 21: Drucksensor, Messsensor, Radsensor
- 22: Verarbeitungseinrichtung, Mikrokontroller
- 23: Sende-/Empfangsschaltung
- 24: lokale Energieversorgung
- 25: Sendesignal, Anfragesignal
- 26: Sendesignal
- 30, 31: Abschnitte des amplitudenmodulierten Signals
- 32: hochfrequentes Trägersignal
- 33: Einhüllende des amplitudenmodulierten Anfragesignals
- 34: Taktsignal
- 35: Störimpuls
- 36: Signaleinbruch im Trägersignal
- 40: Zähler
- 41: Schieberegister
- 42: Schieberegisterstufen mit je 3 Flip-Flops
- 43: Logikschaltung
- 45: D-Flip-Flop
- 46: Schieberegister
- 47: asynchrone Logik

## Patentansprüche

1. Radelektronik (13) für ein Reifenkontrollsystem eines Fahrzeugs (10) zur Messung einer Messgröße, mit einer Auswerteeinrichtung (22), zur Dekodierung eines empfangenen amplitudenmodulierten Anfragesignals (25), mit einer Trägerfrequenz (32), indem aus dem modulierten Trägersignal eine Einhüllende (33) ermittelt wird,
**dadurch gekennzeichnet, dass**
ein digitaler Zähler, der als Gray-Zähler (40) ausgebildet ist und einen Zählereingang zur Einkopplung des Anfragesignals (25) aufweist, sowie
ein Schieberegister (41), das eingangsseitig mit einem Zählerausgang des Zählers verbunden ist, und einer mit dem Ausgang des Schieberegisters (41) verbundenen Logikschaltung (43) vorgesehen ist.

2. Radelektronik (13) nach einem der vorhergehenden Ansprüche,
**dadurch gekennzeichnet,**
**dass** der Zähler als 3-Bitzähler ausgeführt ist.

3. Radelektronik (13) nach einem der vorhergehenden Ansprüche,
**dadurch gekennzeichnet,**
**dass** jeder Ausgang des Zählers mit einem Flip-Flop Eingang einer Schieberegisterstufe verschaltet ist.

4. Radelektronik (13) nach Anspruch 3,
**dadurch gekennzeichnet,**
**dass** das Schieberegister (41) als mehrstufiges Schieberegister (41) ausgebildet ist und mehrere in Reihe zueinander angeordnete Schieberegisterstufen (42) aufweist.

5. Radelektronik (13) nach Anspruch 3 oder 4,
**dadurch gekennzeichnet,**
**dass** das Schleberegister (41) als fünfstufiges Schieberegister (41) ausgebildet ist und insgesamt fünf Schieberegisterstufen (42) und einsprechende fünf Ausgangsanschlüsse aufweist.

6. Radelektronik (13) nach einem der vorhergehenden Ansprüche,
**dadurch gekennzeichnet,**
**dass** das Schieberegister (41), mit einer zur Trägerfrequenz (32) unterschiedlichen Frequenz eines Taktsignals (34) getaktet

7. Radelektronik (13) nach einem der vorhergehenden Ansprüche,
**dadurch gekennzeichnet,**
**dass** ein Teil der Ausgangsanschlüsse der Schleberegisterstufe (42) mit einem Eingang der Logikschaltung (43) verbunden sind und wobei die Logikschaltung (43) an ihrem Ausgangsanschluss einen ersten logischen Pegel ausgibt, wenn alle Schieberegisterstufen (42) den gleichen Ausgangswert aufweisen, und welche einen zweiten logischen Pegel ausgibt, wenn die Ausgangswerte der Schieberegisterstufen (42) zumindest teilweise unterschiedlich sind.

8. Radelektronik (13) nach einem der Ansprüche 6 oder 7,
**dadurch gekennzeichnet,**
**dass** die Logikschaltung (43) durch das Taktsignal (34) getaktet ist.

9. Radelektronik (13) nach einem der Ansprüche 7 oder 8,
**dadurch gekennzeichnet,**
**dass** ein Flip-Flop (45), insbesondere ein D-Flip-Flop, vorgesehen ist, dessen Dateneingang mit einem Ausgangsenschluss der Logikschaltung (43) verbunden ist und in dessen Takteingang das Taktsignal (34) einkoppelbar ist.

10. Radelektronik (13) nach einem der vorhergehenden Ansprüche,
**dadurch gekennzeichnet,**
**dass** eine lokale Energieversorgung (24) vorgesehen ist, die die Elemente der Radelektronik (13) mit Energie versorgt.

11. Reifenkontrollsystem eines Fahrzeugs (10) mit einer Radelektronik (13) nach einem der vorhergehenden Ansprüche.

## Claims

1. Wheel electronic system (13) for a tyre monitoring system of a vehicle (10) for measuring a measurement magnitude, comprising an evaluating device (22), for decoding a received amplitude-modulated interrogation signal (25), with a carrier frequency (32) in which an envelope (33) is determined from the modulated carrier signal, **characterised in that** a digital counter, which is constructed as a Gray counter (40) and has a counter input for coupling in of the interrogation signal (25), a shift register (41) connected at the input side with a counter output of the counter, and a logic circuit (43) connected with the output of the shift register (41) are provided.

2. Wheel electronic system (13) according to the preceding claim, **characterised in that** the counter is constructed as a 3-bit counter.

3. Wheel electronic system (13) according to one of the preceding claims, **characterised in that** each output of the counter is connected with a flip-flop input of a shift register stage.

4. Wheel electronic system (13) according to claim 3, **characterised in that** the shift register (41) is constructed as a multi-stage shift register (41) and has a plurality of shift register stages (42) arranged in series with one another.

5. Wheel electronic system (13) according to claim 3 or 4, **characterised in that** the shift register (41) is constructed as a five-stage shift register (41) and has a total of five shift register stages (42) and correspondingly five output terminals.

6. Wheel electronic system (13) according to any one of the preceding claims, **characterised in that** the shift register (41) is cycled at a frequency of a clock signal (34) different from the carrier frequency (32).

7. Wheel electronic system (13) according to any one of the preceding claims, **characterised in that** a part of the output terminals of the shift register stage (42) is connected with an input of the logic circuit (43) and wherein the logic circuit (43) issues at its output terminal a first logical level when all shift register stages (42) have the same output value and which issues a second logical level when the output values of the shift register stages (42) are at least in part different.

8. Wheel electronic system (13) according to one of claims 6 and 7, **characterised in that** the logic circuit (43) is cycled by the clock signal (34).

9. Wheel electronic system (13) according to one of claims 7 and 8, **characterised in that** the a flip-flop (45), particularly a D flip-flop, is provided, the data input of which is connected with an output terminal of the logic circuit (43) and into the clock input of which the clock signal (34) can be coupled.

10. Wheel electronic system (13) according to any one of the preceding claims, **characterised in that** a local energy supply (24) which supplies the elements of the wheel electronic system (13) with energy is provided.

11. Tyre monitoring system of a vehicle (10) with a wheel electronic system (13) according to any one of the preceding claims.

## Revendications

1. Electronique de roue (13) pour un système de contrôle des pneus d'un véhicule (10) en vue de la mesure d'une grandeur mesurable avec un dispositif d'exploitation pour le décodage d'un signal d'interrogation (25) reçu et modulé en amplitude et de fréquence porteuse (32) de laquelle est détectée une enveloppe (33) provenant du signal porteur modulé,
**caractérisée en ce qu'**elle comporte
• un compteur numérique , sous la forme d'un compteur GRAY et une entrée de comptage pour l'application du signal d'interrogation
• un registre à décalage (41) dont l'entrée est reliée à une sortie de comptage du compteur et
• un circuit logique (43) relié à la sortie du registre à décalage (41).

2. Electronique de roue (13) selon la revendication précédente **caractérisée en ce que** le compteur est un compteur à trois bits.

3. Electronique de roue (13) selon l'une quelconque des revendications précédentes **caractérisée en ce que** chaque sortie du compteur est reliée au circuit d'une entrée Flip-Flop d'un étage du registre à décalage.

4. Electronique de roue (13) selon la revendication 3 **caractérisée en ce que** le registre à décalage (41) est du type registre à décalage multiétages (41) et **en ce qu'**elle comporte plusieurs étages (42) de registre à décalage montés en série l'un à la suite de l'autre.

5. Electronique de roue (13) selon la revendication 3 ou 4 **caractérisée en ce que** le registre à décalage (41) est un registre à décalage à cinq étages présentant au total cinq étages (42) de registre à décalage et cinq jonctions opposées de sortie.

6. Electronique de roue (13) selon l'une quelconque des revendications précédentes **caractérisée en ce que** le registre à décalage (41) est cadencé par un signal de cadencement (34) dont la fréquence est différente de la fréquence porteuse (32).

7. Electronique de roue (13) selon l'une quelconque des revendications précédentes **caractérisée en ce qu'**une partie des jonctions de sortie des étages (42) du registre à décalage est reliée à une entrée du circuit logique (43), et **en ce que** le circuit logique (43) délivre un premier niveau logique sur sa jonction de sortie lorsque tous les étages (42) présentent la même valeur de sortie, et délivre un second niveau logique lorsque les valeurs de sortie des étages de registres à décalage diffèrent au moins partiellement.

8. Electronique de roue (13) selon la revendication 6 ou 7 **caractérisée en ce que** le circuit logique (43) est cadencé par le signal de cadencement (34).

9. Electronique de roue (13) selon la revendication 7 ou 8 **caractérisée en ce que** le Flip-Flop (45) est en particulier un D-Flip-Flop dont l'entrée des données est reliée à une sortie du circuit logique (43) et sur l'entrée de cadencement duquel le signal de cadencement (34) est appliqué.

10. Electronique de roue (13) selon l'une quelconque des revendications précédentes **caractérisée en ce qu'**une alimentation locale (24) en énergie est prévue, qui alimente en énergie les éléments de l'électronique de roue (10).

11. Système de contrôle des pneus d'un véhicule (10) avec une électronique de roue (13) selon l'une quelconque des revendications précédentes.
